# FASCICULE DE BREVET EUROPEEN

(11) **EP 0 892 273 B1**
(45) Date de publication et mention de la délivrance du brevet: **07.04.2004**
(21) Numéro de dépôt: 98202030.7
(22) Date de dépôt: 17.06.1998
(51) Int. Cl.: G01R 22/00, H02M 3/335

(54) **Circuit d'alimentation pour un compteur d'électricité**
Versorgungsschaltung für einen Elektizitätszähler
Supply circuit for an electricity meter

(30) Priorité: 17.07.1997 FR 9709201
(43) Date de publication de la demande: 20.01.1999
(73) Titulaire: Schlumberger Industries S.A., 92542 Montrouge Cedex (FR)
(72) Inventeur: Zaim, Brahim, 86800 Sèvres Anxaumont (FR)
(74) Mandataire: Feray, Valérie

(56) Documents cités:
- EP-A- 0 129 454
- WO-A-92/05614
- GB-A- 2 286 250

## Description

La présente invention est relative à un compteur d'électricité électronique comprenant un circuit métrologique pour mesurer la consommation d'électricité et un circuit d'alimentation comprenant un condensateur principal alimenté par un réseau électrique et un transformateur à découpage possédant au moins un primaire enroulé autour du tore du transformateur et au moins un secondaire enroulé autour du primaire, le primaire étant branché au condensateur principal via un circuit de commutation et le secondaire étant branché au circuit métrologique.

L'utilisation d'un transformateur réglé par un circuit de découpage ("transformateur à découpage") dans un circuit d'alimentation comme convertisseur "DC/DC" est bien connu dans le contexte des compteurs électroniques. Le condensateur principal est branché et débranché en alternance au primaire du transformateur par le circuit de commutation pour générer une tension au secondaire du transformateur. La tension ainsi obtenue est filtrée et fournie au circuit métrologique. Le transformateur à découpage est contrôlé pour fournir une tension relativement constante au circuit métrologique.

Ce réglage de tension est typiquement effectué au moyen d'un bobinage de retour qui surveille la tension du secondaire et qui envoie un signal de contrôle au circuit de commutation pour contrôler le temps de connexion du condensateur principal au transformateur. Le bobinage de retour est typiquement enroulé autour du tore entre le primaire et le secondaire. Le bobinage de retour possède un fort couplage avec le secondaire pour surveiller de façon précise la variation de la tension aux sorties des secondaires afin de générer le signal de contrôle envoyé au circuit de commutation.

Il est à noter que la masse du circuit métrologique est souvent différente de celle du circuit d'alimentation. Par exemple, pour un compteur polyphasé apte à fonctionner dans le cas d'une perte de neutre, le condensateur principal sera alimenté par un courant résultant du redressement de toutes les phases et du neutre effectué relatif à une masse qui est commune au redresseur et au circuit d'alimentation et qui est différente du neutre. Par contre, la masse du circuit métrologique est simplement constituée par le neutre.

Dans le cas d'une coupure de courant, l'alimentation du circuit métrologique sera assurée pendant une période de temps par la charge stockée dans le condensateur. Pour identifier une coupure de courant et déterminer la quantité de charge qui reste, le circuit métrologique doit surveiller l'évolution de la tension aux bornes du condensateur principal. Or, étant donné la différence entre la masse du circuit d'alimentation et celle du circuit métrologique, il n'est pas possible pour le circuit métrologique de mesurer directement la tension.

Dans des systèmes conventionnels, une mesure de la tension est faite via une interface isolante entre les deux circuits, par exemple, en utilisant un optocoupleur ou un amplificateur différentiel apte à mesurer la différence de potentiel entre les bornes du condensateur. Ces solutions sont relativement chères et nécessitent l'utilisation d'un grand nombre de composants pour définir l'interface.

Le document EP 0 129 454 se rapporte à un procédé de mesure de l'autonomie d'une alimention électrique à découpage et dispositif pour sa mise en oeuvre.

L'un des objets de la présente invention est de surmonter les problèmes associés aux systèmes connus pour permettre la surveillance de la tension du condensateur du circuit d'alimentation avec le minimum de composants additionnels.

Un compteur d'électricité selon la présente invention se caractérise par un circuit de surveillance comprenant un bobinage supplémentaire enroulé autour du tore du transformateur entre le tore et au moins une partie du primaire, ainsi qu'un circuit d'intégration branché en parallèle avec le bobinage supplémentaire et dimensionné pour fournir une tension sensiblement proportionnelle à la tension du condensateur principal.

Le bobinage supplémentaire, positionné entre le tore du transformateur et le primaire, possède un couplage très fort avec le primaire. Par contre, il est blindé par le primaire des effets des courant circulants dans les bobinages secondaires et dans le bobinage de retour. L'effet du couplage entre le bobinage supplémentaire et le primaire est de permettre au bobinage supplémentaire de suivre étroitement l'évolution de la tension sur le condensateur principal et ainsi fournir une indication d'une coupure de courant et une mesure de la charge qui reste dans le condensateur.

Le bobinage supplémentaire peut être enroulé directement autour du tore entre le tore et le primaire. Cependant, d'autres modes de réalisations sont possibles, par exemple, dans lesquels le primaire est divisé en deux parties, le bobinage supplémentaire étant enroulé entre les deux parties du primaire. Toutefois, le bobinage supplémentaire sera blindé par le primaire à l'encontre des effets des courants circulants dans les bobinages secondaires et/ou circulants dans un bobinage de retour.

Comme il sera compris, en comparaison avec les systèmes de surveillance conventionnels, la solution de la présente invention est peu coûteuse et peut être implémentée avec un petit nombre de composants.

Comme nous l'avons décrit ci-dessus, dans un transformateur à découpage, la tension du condensateur principal est appliquée pour une période de temps variable. Cette période de temps est déterminée par le signal de contrôle reçu, par exemple, du bobinage de retour. Le but de ce système de contrôle est d'assurer une tension relativement constante aux sorties du secondaire. Le bobinage de retour a un fort couplage avec le secondaire et génère un signal de contrôle qui répond rapidement aux changements de tension du secondaire. Il est ainsi impossible de déterminer la valeur de la tension du condensateur principal en utilisant la valeur de la tension à la sortie du secondaire.

Par contre, dans le circuit de surveillance, le fort couplage entre le bobinage supplémentaire et le primaire, ainsi que le faible couplage entre le bobinage de retour et le bobinage supplémentaire et le dimensionnement du circuit d'intégration permettent au circuit de surveillance de fournir une image fidèle de la tension du condensateur, malgré le découpage de la tension effectué par le circuit de commutation.

Les valeurs exactes des composants dans le circuit d'intégration seront choisies par le constructeur en fonction des autres paramètres du système, notamment les tensions et les courants circulant dans le circuit, les dimensions du transformateur, etc. Néanmoins, pour assurer un bon fonctionnement du circuit de surveillance, le circuit d'intégration est dimensionné pour avoir une constante de temps relativement petite.

Dans un circuit d'intégration composé d'un condensateur et d'une résistance, la valeur de la résistance est normalement relativement élevée et la valeur du condensateur est normalement relativement basse.

En comparaison, le circuit de filtrage positionné entre un bobinage secondaire et le circuit métrologique est normalement défini par une constante de temps relativement grande et est muni d'un grand condensateur.

De préférence, le nombre de spires du bobinage supplémentaire est relativement petit par rapport au nombre de spires du bobinage primaire. Par exemple, dans le cas d'un rapport de valeur 40:1 entre la tension du condensateur principal et la tension mesurée par le circuit de surveillance, le ratio entre le nombre de spires du bobinage supplémentaire et le nombre de spires du bobinage primaire peut avoir une valeur de 1:33. Comme il sera compris, la valeur exacte du ratio dépend des dimensionnements du circuit, du couplage entre le primaire et le tore, du couplage entre le tore et le bobinage supplémentaire etc.

De préférence, le circuit d'intégration est également muni d'une diode pour redresser le courant en sortie du bobinage supplémentaire.

La présente invention s'applique notamment à un circuit d'alimentation pour un compteur d'électricité avec un transformateur à découpage muni d'un bobinage de retour qui surveille la tension du secondaire pour fournir un signal de contrôle au circuit de commutation.

D'autres modes de réalisations d'un transformateur à découpage sont connus, par exemple, qui utilisent un capteur pour mesurer directement la tension du secondaire pour générer le signal de contrôle appliqué au circuit de découpage. Or, un bobinage de retour représente la solution optimale étant donné la nécessité d'isoler le primaire du secondaire du transformateur.

Dans un mode de réalisation préféré de la présente invention, le transformateur à découpage possède deux secondaires ayant une masse commune et enroulés autour du transformateur en sens contraires l'un de l'autre pour fournir respectivement une tension positive et une tension négative.

La plupart des circuits métrologiques utilisés dans le comptage ont besoin d'une alimentation apte à fournir une tension positive et une tension négative et ce mode de réalisation répond à ce besoin.

L'invention sera mieux comprise à la lecture de la description qui suit d'un mode de réalisation de l'invention, donnée à titre d'exemple illustratif et non-limitatif et faisant références aux dessins annexés sur lesquels :
Fig. 1 montre l'architecture générale d'un compteur électrique;
Fig. 2 montre l'architecture d'un convertisseur continu/continu suivant la présente invention comprenant un transformateur couplé avec un régulateur PWM;
Fig. 3 est un schéma de l'aménagement interne des différents enroulements autour du tore dans le transformateur de la figure 2;
Fig. 4 est la courbe de la sortie du bobinage supplémentaire en fonction de la tension aux bornes du condensateur principal; et
Fig. 5 montre l'évolution temporelle de la tension en sortie du bobinage supplémentaire et de la tension au bornes du condensateur principal.

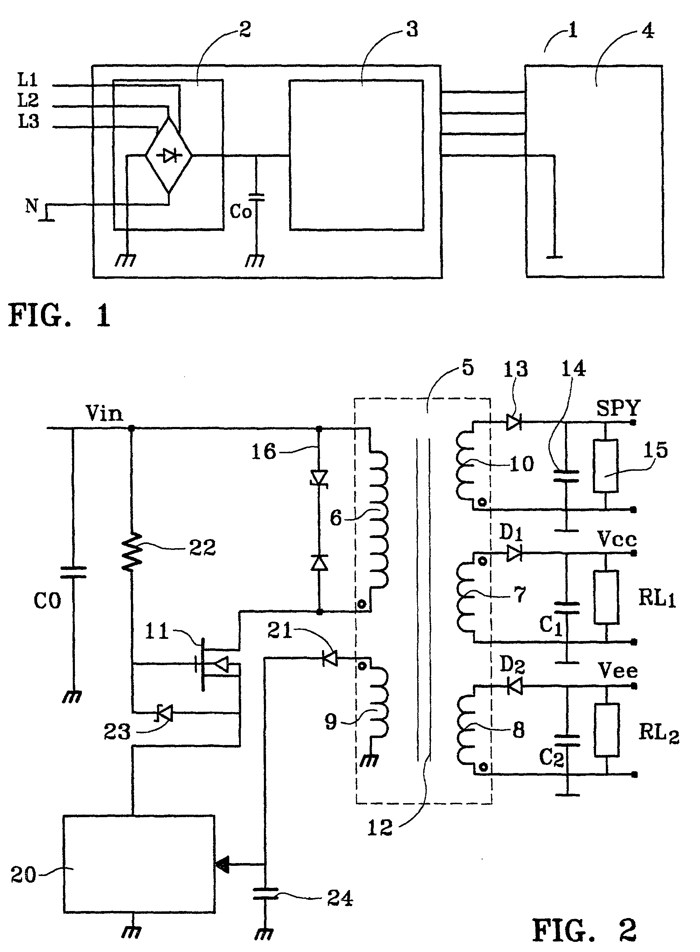

La figure 1 fait apparaître l'organisation interne d'un exemple de compteur triphasé qui peut supporter une perte de neutre. Ce compteur référencé par 1 est formé d'un circuit d'alimentation comprenant une partie redresseur 2 et une partie convertisseur continu/continu 3 ainsi que d'un circuit métrologique 4. La première partie, le circuit redresseur 2, permet la connexion du compteur 1 aux trois phases L₁, L₂, L₃ et au neutre N du réseau triphasé et fournit en sortie une tension continue à un condensateur principal Cₒ. Le but de l'invention est d'obtenir une image de cette tension continue aux bornes de Cₒ que l'on retrouve en entrée du circuit convertisseur continu/continu 3 afin de détecter d'éventuelles chutes de courant dans le réseau.

Le circuit redresseur 2 et le circuit convertisseur 3, alimentent le circuit métrologique 4. Comme le montre la figure 2, le circuit convertisseur continu/continu utilisé se compose d'un circuit de commutation avec un régulateur PWM 20 et d'un transformateur 5. On reconnaît aussi en entrée le condensateur principal Cₒ dont on veut obtenir l'image de la tension.

Les circuits d'alimentation et le circuit métrologique n'ont pas la même référence de potentiels. Ainsi le condensateur Cₒ, le régulateur PWM 20 et le circuit primaire 6 du transformateur 5 sont référencés par rapport à la masse du circuit tandis que l'ensemble du circuit secondaire composé des éléments 7, 8, 10, qui alimente le circuit métrologique, ainsi que le circuit métrologique lui même est référencé par rapport au neutre. Comme il sera compris il est difficile de faire une mesure directe de la tension aux bornes du condensateur principal au niveau du secondaire car les références de potentiels ne sont pas les mêmes.

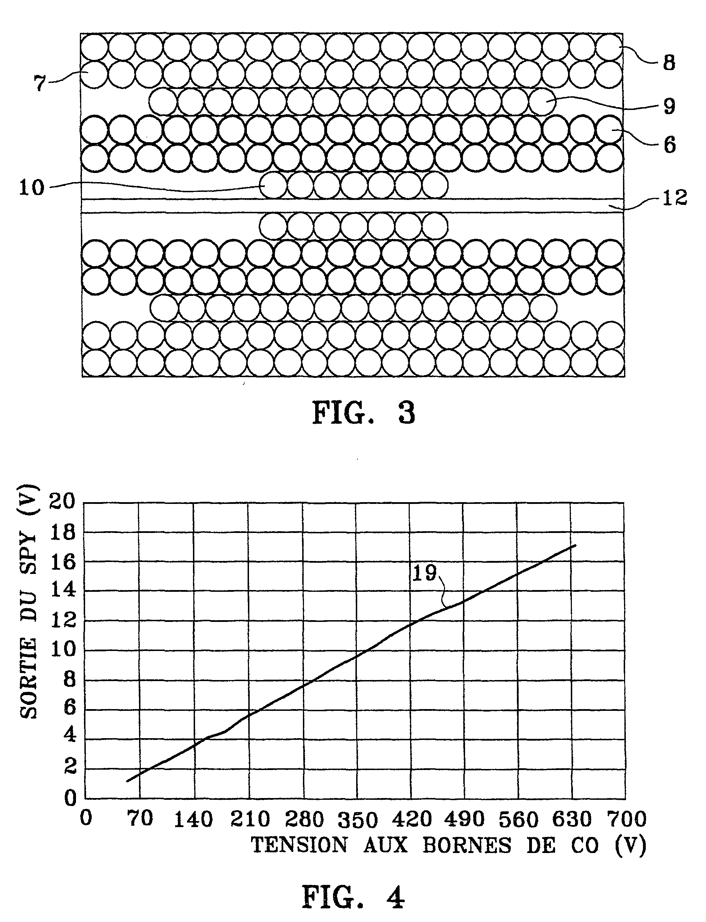

Le transformateur 5 utilisé, présenté en figure 3, est formé initialement de quatre bobinages successifs différents : un bobinage primaire 6 qui s'enroule autour du tore 12, un bobinage de retour 9 autour du bobinage primaire 6, un premier bobinage secondaire 7 autour du bobinage de retour 9 et enfin un deuxième bobinage secondaire 8 autour du premier bobinage secondaire 7. Pour obtenir une image fidèle de la tension du condensateur Cₒ, que l'on retrouve d'ailleurs aux bornes du primaire 6, un bobinage supplémentaire 10 est inséré entre le tore 12 et le bobinage primaire 6 selon la présente invention.

On veut obtenir à la sortie des deux circuits secondaires une tension continue et constante. Une tension positive Vcc doit être obtenue en sortie du premier circuit secondaire et symétriquement une tension négative Vee doit être obtenue en sortie du deuxième circuit secondaire. Pour cela, chaque circuit secondaire comporte une diode, un condensateur et une résistance placés en parallèle du bobinage.

On branche par exemple une diode D₁ après le bobinage 7, un condensateur C₁ et une résistance RL₁ en parallèle au bobinage et à la diode pour obtenir une tension positive Vcc. De même branche par exemple une diode D₂ après le bobinage 8, un condensateur C₂ et une résistance RL₂ en parallèle au bobinage et à la diode pour obtenir une tension négative Vee.

Le sens d'enroulement des bobinages, indiqué sur les schémas de manière conventionnelle par le point situé à côté de chaque bobinage, et l'orientation des diodes sont inversés entre les 2 circuits pour obtenir respectivement une tension positive à la sortie du premier circuit secondaire et une tension négative à la sortie du deuxième circuit secondaire.

Le bobinage de retour 9 relié à une diode 21 et à un condensateur 24 surveille la tension aux bornes des circuits secondaires et a pour rôle de modifier la tension au primaire pour obtenir les tensions continues en sortie des circuits secondaires. Il y a un couplage fort entre le bobinage de retour et les secondaires. Ce circuit retour, sous l'influence des circuits secondaires, contrôle le régulateur PWM 20 et un transistor 11. Ces deux derniers forment un circuit de commutation qui contrôle le temps de connexion du condensateur principal Cₒ au bobinage primaire 6. Un circuit 16, composé d'une diode Zener et d'une diode classique, est par ailleurs introduit en parallèle au bobinage primaire pour limiter la surtension due à la force électromotrice induite dans la self du primaire lors de l'ouverture du circuit de commutation. De façon identique une diode Zener est placée en parallèle au transistor 11 pour le protéger d'une trop forte tension appliquée à ses bornes. Une résistance 22 permet la polarisation de la diode Zener 23 afin de commander le transistor et protéger son entrée des surtensions.

L'emplacement des bobinages dans le transformateur 5 confère à chacun un rôle particulier. Ainsi l'ajout d'un nouveau bobinage 10 suivant l'invention ne se fait forcement entre le tore 12 et le primaire 6 car il ne doit subir que l'influence du bobinage primaire. Comme le montre la figure 3, le bobinage supplémentaire 10 se trouve éloigné du bobinage de retour 9, et de ce fait ne joue aucun rôle sur la régulation qui résulte de ce bobinage de retour 9 et inversement ne subit pas l'influence de ce bobinage.

On prend par exemple un bobinage primaire 6 de 132 tours, un premier bobinage secondaire 7 de 23 tours, un deuxième bobinage secondaire 8 de 17 tours, un bobinage de retour 9 de 34 tours et un bobinage supplémentaire 10 de 4 tours. Les 132 tours du bobinage primaire sont suffisants pour créer un blindage autour du bobinage supplémentaire pour que celui-ci ne subisse pas l'influence du bobinage de retour et le nombre de spires du bobinage supplémentaire est petit par rapport à celui du primaire et peu coûteux.

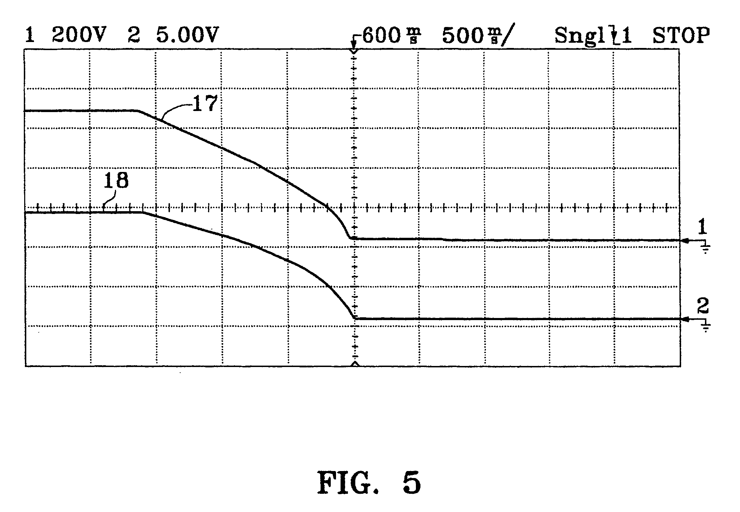

La figure 5 fournit les indications des valeurs des tensions aux bornes du condensateur et en sortie. Pour une tension de 200 V à l'entrée du circuit convertisseur continu/continu on retrouve une tension de 5 V en sortie. Il existe un rapport de 40:1 entre les deux tensions. Le ratio entre le nombre de spires du bobinage supplémentaire et le nombre de spires du bobinage primaire est de préférence de 1:33.

Finalement, le bobinage supplémentaire possède un couplage très fort avec le primaire uniquement. Grâce à une diode 13 reliée au bobinage supplémentaire et à un circuit d'intégration de constante de temps très faible, la tension obtenue en sortie est une image fidèle de la tension au primaire et donc de celle aux bornes du condensateur Cₒ. Le circuit d'intégration, défini par le condensateur 14, la résistance 15, et la diode 13, est dimensionné pour permettre un filtrage de la tension et pour ne pas rendre compte du découpage de la tension du bobinage primaire engendré par le circuit de commutation.

Dans ce mode de réalisation, les composants utilisés dans les circuits de sorties de chacun des bobinages 7, 8, 10 ont les valeurs suivantes :
Condensateur 14 = 100 nF
Condensateur C1 = 220 µF
Condensateur C2 = 220 µF
Résistance 15 = 167,3 KΩ
Résistance RL1 = 62 Ω
Résistance RL2 = 250 Ω

Les valeurs RL1 et RL2 seront déterminées plus précisément par la résistance du circuit métrologique du compteur.

Le figure 4 montre la relation de linéarité obtenue entre la tension en sortie et celle aux bornes du condensateur Cₒ. La figure 5 montre l'affichage d'un oscilloscope branché pour comparer l'évolution temporelle de la tension aux bornes du condensateur Cₒ, courbe 17, et celle de la tension à la sortie, courbe 18. A un décalage près la tension en sortie reproduit la tension aux bornes du condensateur Cₒ. Une variation de la tension aux bornes du condensateur engendre immédiatement une variation de la tension en sortie. Une chute de tension dans l'alimentation du réseau sera de ce fait instantanément reproduite et identifiée à la sortie.

## Revendications

1. Compteur d'électricité électronique comprenant un circuit métrologique et un circuit d'alimentation, comprenant un condensateur principal (Cₒ) alimenté par un réseau électrique et un transformateur à découpage (5) possédant au moins un primaire enroulé autour du tore (6) du transformateur et au moins un secondaire enroulé autour du primaire (10), le primaire étant branché au condensateur principal via un circuit de commutation (20, 11) et le secondaire étant branché au circuit métrologique, **caractérisé par** un circuit de surveillance comprenant un bobinage supplémentaire (10) enroulé autour du tore du transformateur entre le tore et au moins une partie du primaire, ainsi qu'un circuit d'intégration (14, 15) branché en parallèle avec le bobinage supplémentaire et dimensionné pour fournir une tension (SPY) entre les points de connexion de la sotie du circuit d'intégration sensiblement proportionnelle à la tension du condensateur principal.

2. Compteur d'électricité électronique suivant la revendication 1 dans lequel le circuit d'intégration est dimensionné pour avoir une constante de temps relativement petite en comparaison avec un circuit de filtrage du circuit métrologique.

3. Compteur d'électricité électronique suivant la revendication 1 ou 2 dans lequel le circuit d'intégration est composé d'un condensateur et d'une résistance et la valeur de la résistance étant relativement élevée et la valeur du condensateur étant relativement basse en comparaison avec un circuit de filtrage du circuit métrologique.

4. Compteur d'électricité électronique suivant l'une quelconque des revendications 1 à 3 dans lequel le nombre de spires du bobinage supplémentaire est relativement petit par rapport au nombre de spires du bobinage primaire.

5. Compteur d'électricité électronique suivant la revendication 4 dans lequel le ratio entre le nombre de spires du bobinage supplémentaire et le nombre de spires du bobinage primaire a une valeur de 1:33.

6. Compteur d'électricité électronique suivant l'une quelconque des revendications 1 à 5 dans lequel le circuit d'intégration est également muni d'une diode pour redresser le courant en sortie du bobinage supplémentaire.

7. Compteur d'électricité électronique suivant l'une quelconque des revendications 1 à 6 dans lequel le transformateur à découpage est muni d'un bobinage de retour qui surveille la tension du secondaire pour fournir un signal de contrôle au circuit de commutation.

8. Compteur d'électricité électronique suivant l'une quelconque des revendications 1 à 7 dans lequel le transformateur à découpage possède deux secondaires ayant une masse commune et enroulés autour du transformateur en sens contraires l'un de l'autre pour fournir respectivement une tension positive et une tension négative.

9. Compteur d'électricité électronique suivant l'un quelconque des revendications 1 à 8 dans lequel le condensateur principal et le primaire du transformateur sont référencés par rapport à une première masse et le circuit métrologique et le secondaire du transformateur sont référencés par rapport au neutre.

## Claims

1. Electronic electricity meter comprising a metering circuit and a supply circuit comprising a main capacitor (Cₒ) supplied by an electric network and a switch mode transformer (5) having at least one primary wound around the core (6) of the transformer and at least one secondary wound around the primary (10), the primary being connected to the main capacitor via a switch circuit (20,11) and the secondary being connected to the metering circuit, **characterized by** a monitoring circuit comprising an additional winding (10) wound around the transformer core between the core and at least part of the primary, and an integration circuit (14, 15) connected in parallel with the additional winding and scaled to provide a voltage (SEV) between the connection points of the integration circuit output that is substantially proportional to the voltage of the main capacitor.

2. Electronic electricity meter as in claim I, in which the integration circuit is sized to have a relatively small time constant compared with a filter circuit of the metering circuit.

3. Electronic electricity meter as in claim 1 or 2, in which the integration circuit consists of a capacitor and a resistance, the resistance value being relatively high and the capacitor value being relatively low compared with a filter circuit of the metering circuit.

4. Electronic electricity meter as in any of claims 1 to 3, in which the number of turns of the additional winding is relatively small compared with the number of turns of the primary winding.

5. Electronic electricity meter as in claim 4, in which the ratio between the number of turns of the additional winding and the number of turns of the primary winding has a value of 1:33.

6. Electronic electricity meter as in any of claims 1 to 5, in which the integration circuit is also provided with a diode to rectify the current at the output of the additional winding.

7. Electronic electricity meter as in any of claims 1 to 6, in which the switch mode transformer is provided with a return winding which monitors the voltage of the secondary to give a control signal to the switch circuit.

8. Electronic electricity meter as in any of claims 1 to 7, in which the switch mode transformer has two secondaries having a common earth and wound around the transformer in opposite direction to one another to provide a positive voltage and a negative voltage respectively.

9. Electronic electricity meter as in any of claims 1 to 8, in which the main capacitor and the primary of the transformer are referenced relative to a first earth and the metering circuit and the secondary of the transformer are referenced relative to neutral.

## Patentansprüche

1. Elektronischer Stromzähler, umfassend einen Messkreis und einen Versorgungskreis, der einen durch ein Stromnetz versorgten Hauptkondensator (Cₒ) aufweist und einen Schalttransformator (5), der mindestens eine Primärwicklung (6) um den Kern des Transformators und mindestens eine Sekundärwicklung (10) um die Primärwicklung hat, wobei die Primärwicklung an den Hauptkondensator über einen Schaltkreis (20, 11) und die Sekundärwicklung an den Messkreis angeschlossen ist, **gekennzeichnet durch** einen Überwachungskreis, aufweisend eine zusätzliche Bewicklung (10) um den Transformatorkern zwischen dem Kern und mindestens einem Teil der Primärwicklung, sowie einen Integrationskreis (14, 15), der parallel an die zusätzliche Bewicklung angeschlossen ist und so dimensioniert, um zwischen den Anschlusspunkten des Ausgangs des Integrationskreises eine Spannung (SPY) zu liefern, die sich etwa proportional zur Spannung des Hauptkondensators verhält.

2. Elektronischer Stromzähler nach Anspruch 1, wobei der Integrationskreis so dimensioniert ist, dass er im Vergleich mit einem Filterkreis des Messkreises eine relativ kleine Zeitkonstante hat.

3. Elektronischer Stromzähler nach Anspruch 1 oder 2, wobei der Integrationskreis aus einem Kondensator und einem Widerstand besteht, wobei im Vergleich mit einem Filterkreis des Messkreises der Wert des Widerstands relativ hoch und der Wert des Kondensators relativ niedrig ist.

4. Elektronischer Stromzähler nach einem der Ansprüche 1 bis 3, wobei die Anzahl der Windungen der zusätzlichen Bewicklung im Vergleich mit der Anzahl der Windungen der Primärwicklung relativ gering ist.

5. Elektronischer Stromzähler nach Anspruch 4, wobei der Koeffizient, der sich aus der Anzahl der Windungen der zusätzlichen Bewicklung und der Anzahl der Windungen der Primärwicklung ergibt, 1:33 ist.

6. Elektronischer Stromzähler nach einem der Ansprüche 1 bis 5, wobei der Integrationskreis auch mit einer Diode ausgerüstet ist, um den aus der zusätzlichen Bewicklung austretenden Strom gleichzurichten.

7. Elektronischer Stromzähler nach einem der Ansprüche 1 bis 6, wobei der Schalttransformator mit einer Umkehrwicklung ausgestattet ist, die die Spannung der Sekundärwicklung überwacht, um dem Schaltkreis ein Kontrollsignal zu liefern.

8. Elektronischer Stromzähler nach einem der Ansprüche 1 bis 7, wobei der Schalttransformator zwei Sekundärwicklungen hat, die eine gemeinsame Masse haben und um den Transformator gegensinnig gewickelt sind, um jeweils eine positive und eine negative Spannung zu liefern.

9. Elektronischer Stromzähler nach einem der Ansprüche 1 bis 8, wobei der Hauptkondensator und die Primärwicklung des Transformators mit einer Primärmasse und der Messkreis und die Sekundärwicklung des Transformators mit dem Nullleiter in Beziehung stehen.
